# FASCICULE DE BREVET EUROPEEN

(11) **EP 1 271 646 B1**
(45) Date de publication et mention de la délivrance du brevet: **23.02.2011**
(21) Numéro de dépôt: 02291371.9
(22) Date de dépôt: 04.06.2002
(51) Int. Cl.: H01L 23/473, H01L 23/373

(54) **Module électronique de puissance et composant de puissance destiné à équiper un tel module**
Elektronischer Leistungsmodul und Leistungsbauelement für diesen Modul
Electronic power module and power component for such a module

(30) Priorité: 20.06.2001 FR 0108099
(43) Date de publication de la demande: 02.01.2003
(73) Titulaire: ALSTOM Transport SA, 92300 Levallois-Perret (FR)
(72) Inventeur: Beuille, Christophe, 65000 Tarbes (FR); Breit, Fabrice, 65710 Campan (FR)
(74) Mandataire: Blot, Philippe Robert Emile

(56) Documents cités:
- EP-A- 0 637 078
- EP-A- 0 645 816
- EP-A- 0 814 509
- US-A- 5 146 314
- US-A- 5 606 201
- US-A- 5 923 086

## Description

L'invention se rapporte à un module électronique de puissance comportant au moins un composant de puissance disposé sur un substrat électriquement isolant et à un composant semi-conducteur de puissance destiné à équiper un tel substrat. Le module électronique de puissance selon l'invention est notamment destiné à être utilisé pour le montage de transistors bipolaires à grille isolée, dits composants IGBT, dans les circuits de distribution d'énergie du domaine ferroviaire.

Il est connu que les performances des modules électroniques de puissance sont limitées par la température atteinte par les composants électroniques de puissance en fonctionnement. Par exemple, au delà de 150°C, une puce silicium voit ses performances fortement dégradées. De ce fait, il est très important d'évacuer efficacement la chaleur dissipée par effet joule, de façon à maintenir, dans les composants, une température de fonctionnement optimale et ainsi pouvoir augmenter les puissances utilisables ou la fiabilité du système.

De manière habituelle, les modules électroniques de puissance destinés à la traction ferroviaire sont constitués d'un composant de puissance brasé sur un substrat comprenant une tranche électriquement isolante en nitrure d'aluminium AlN recouverte sur ses faces inférieure et supérieure d'une métallisation de cuivre par un procédé dénommé DBC (Direct Bonding Copper), le substrat étant refroidi par un radiateur qui est accolé à la couche de cuivre inférieure. De tels modules électroniques présentent toutefois l'inconvénient d'avoir des couches d'accroche au niveau des brasures et métallisations qui constituent des barrières thermiques réduisant considérablement les capacités de transmission de chaleur au travers du substrat ce qui limite la dissipation d'énergie au travers du radiateur de refroidissement.

Le but de la présente invention est donc de proposer un module électronique de puissance qui remédie à ces inconvénients en assurant un excellent refroidissement des composants de puissance.

A cet effet, l'invention a pour objet un module électronique de puissance comportant au moins un composant semi-conducteur de puissance disposé sur un substrat électriquement isolant, caractérisé en ce que le composant semi-conducteur de puissance comporte une face accolée au substrat qui est pour partie recouverte d'une couche de diamant et pour partie métallisée, la partie métallisée étant au contact d'une piste conductrice réalisée sur la surface du substrat et la partie recouverte de diamant étant en regard d'une ouverture réalisée dans le substrat, ce dernier comportant une face opposée au composant semi-conducteur qui est refroidie par un fluide caloporteur, le fluide caloporteur s'écoulant dans l'ouverture et à la surface de la partie recouverte de diamant.

Selon des modes particuliers de réalisation, le module électronique de puissance peut comprendre l'une ou plusieurs des caractéristiques suivantes prises isolément ou selon toutes les combinaisons techniquement possibles :
- la face du composant semi-conducteur de puissance qui est accolée au substrat est métallisée sur sa périphérie et recouverte d'une couche diamant sur le reste de sa surface ;
- la couche de diamant est déposée sur le composant semi-conducteur de puissance par CVD (Chimical Vapor Déposition) ;
- la couche de diamant recouvrant le composant de semi-conducteur de puissance forme une surépaisseur qui est insérée dans l'ouverture du substrat, cette dernière comportant une forme complémentaire à la forme de la couche de diamant ;
- le composant semi-conducteur de puissance est un composant IGBT ;
- le substrat est en nitrure d'aluminium AlN ou en alumine.

L'invention concerne également un composant semi-conducteur de puissance destiné à équiper un tel module électronique de puissance, caractérisé en ce qu'il comporte une face destinée à être accolée à un substrat qui est pour partie métallisée et pour partie recouverte d'une couche de diamant.

Selon une autre caractéristique du composant semi-conducteur de puissance selon l'invention, la face est métallisée sur sa périphérie et recouverte d'une couche diamant sur le reste de sa surface ;

On comprendra mieux les buts, aspects et avantages de la présente invention, d'après la description donnée ci-après d'un mode de réalisation de l'invention, présenté à titre d'exemple non limitatif, en se référant aux dessins annexés, dans lesquels :
- La figure 1 est une vue en coupe schématique, d'un mode de réalisation du module électronique de puissance selon l'invention ;
- La figure 2 est une vue de dessous schématique du composant de puissance équipant le module de puissance de la figure 1 ;

Pour faciliter la lecture du dessin, seuls les éléments nécessaires à la compréhension de l'invention ont été représentés.

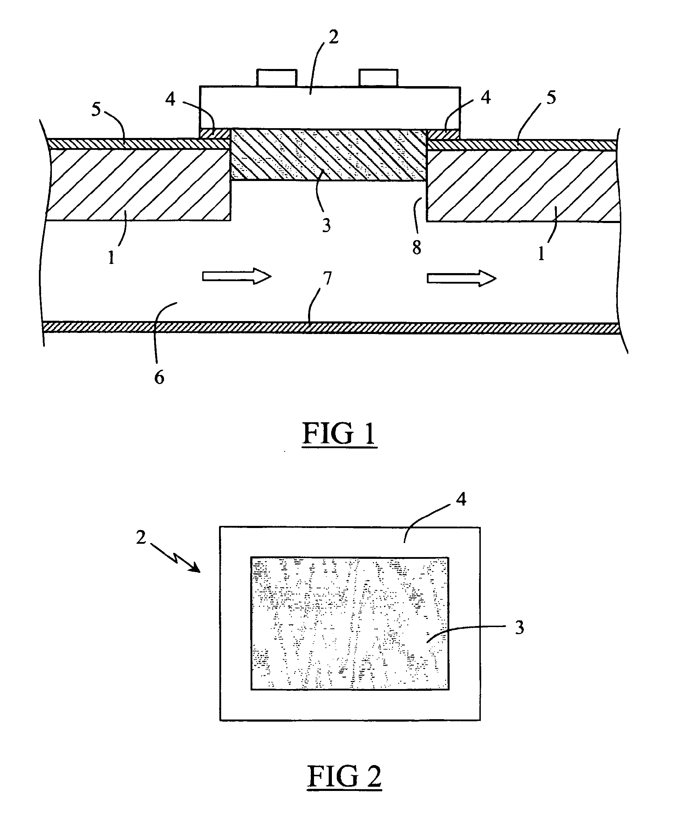

La figure 1 représente un module électronique de puissance comportant un composant semi-conducteur de puissance 2, tel qu'un composant IGBT, disposé sur un substrat 1 en nitrure d'aluminium AlN ou en alumine.

Le composant IGBT 2, représenté schématiquement sur la figure 2, présente une face inférieure qui est pourvue sur sa périphérie d'une piste conductrice 4 constituant un collecteur et qui est recouverte en son centre d'une couche de diamant 3 de forme rectangulaire. Le composant IGBT 2 possède également de manière classique une connexion de commande et un émetteur sur sa face supérieure. La couche de diamant 3 qui recouvre l'ensemble de la face inférieure du composant IGBT, à l'exception de la partie réservée à la piste conductrice, est obtenue de manière connu en soi par dépôt chimique en phase vapeur (CVD) sur la face en silicium du composant 2 sur une épaisseur de l'ordre 150 µm, la piste conductrice 4 étant réalisée au moyen d'un masque par métallisation de la périphérie de la face du composant 2 sur une épaisseur de l'ordre de 5 µm.

Conformément à la figure 1, le composant IGBT 2 est accolé au substrat 1 en amenant la piste conductrice 4 au contact d'une piste conductrice en cuivre 5 supportée par le substrat 1, et en insérant la surépaisseur de la couche de diamant 3 dans une ouverture 8 de forme complémentaire réalisée dans le substrat 1. Cette ouverture 8 traverse le substrat 1 et débouche sur la face inférieure du substrat 1 qui est balayée par un fluide caloporteur 6 canalisé par ailleurs par la paroi 7 d'un boîtier de refroidissement.

Le module de puissance ainsi réalisé possède un composant IGBT dont la majeure partie de la face inférieure est refroidie par conduction au travers de la couche de diamant qui est au contact du fluide caloporteur permettant ainsi, grâce à l'excellente conductivité thermique de la couche en diamant de l'ordre de 1500 à 2000 W/m.K, d'évacuer une grande énergie thermique en direction du fluide caloporteur tout en assurant une bonne isolation électrique entre le fluide caloporteur et le composant de puissance grâce aux propriétés diélectriques du diamant. De plus, un tel module de puissance présente l'avantage d'être utilisable avec les composants à technologie verticale, pour lesquels le courant traverse le composant, grâce à la connexion du composant semi-conducteur de puissance au niveau de la périphérie de sa face inférieure.

Le module électronique de puissance selon l'invention assure donc un refroidissement optimal du composant semi-conducteur de puissance ce qui permet d'utiliser les composants IGBT avec de plus forte tension ou de plus fort courant et donc de réduire le nombre de composants nécessaires à la réalisation d'un convertisseur de puissance dans une chaîne de traction d'un véhicule ferroviaire.

Bien entendu, l'invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention.

Ainsi, dans des variantes de réalisation non représentées, l'emplacement et la forme de la piste conductrice et de la couche de diamant sur la face inférieure du composant semi-conducteur de puissance pourront être réalisés différemment.

## Revendications

1. Module électronique de puissance, comportant au moins un composant semi-conducteur de puissance (2) disposé sur un substrat (1) électriquement isolant, **caractérisé en ce que** ledit composant semi-conducteur de puissance (2) comporte une face accolée audit substrat (1) qui est pour partie recouverte d'une couche de diamant (3) et pour partie métallisée (4), ladite partie métallisée (4) étant au contact d'une piste conductrice (5) réalisée à la surface du substrat (1) et ladite partie recouverte de diamant (3) étant en regard d'une ouverture (8) réalisée dans le substrat (1), ledit substrat (1) comportant une face opposée au composant semi-conducteur (2) qui est refroidie par un fluide caloporteur (6), ledit fluide s'écoulant dans ladite ouverture (8) et à la surface de la partie recouverte de diamant (3).

2. Module électronique de puissance selon la revendication 1, **caractérisé en ce que** la face du composant semi-conducteur de puissance (2) qui est accolée au substrat est métallisée sur sa périphérie et recouverte d'une couche diamant (3) sur le reste de sa surface.

3. Module électronique de puissance selon l'une quelconque des revendications 1 à 2, **caractérisé en ce que** ladite couche de diamant (3) est déposée sur le composant semi-conducteur de puissance (2) par CVD (Chimical Vapor Deposition).

4. Module électronique de puissance selon l'une quelconque des revendications 1 ou 3, **caractérisé en ce que** la couche de diamant (3) recouvrant le composant de semi-conducteur de puissance (2) forme une surépaisseur qui est insérée dans l'ouverture (8) du substrat, ladite ouverture (8) comportant une forme complémentaire à la forme de la couche de diamant (3).

5. Module électronique de puissance selon l'une quelconque des revendications 1 à 4, **caractérisé en ce que** le composant semi-conducteur de puissance (2) est un composant IGBT.

6. Module électronique de puissance selon l'une quelconque des revendications 1 à 5, **caractérisé en ce que** ledit substrat (1) est en nitrure d'aluminium AIN ou en alumine.

7. Composant semi-conducteur de puissance destiné à équiper un module de puissance selon l'une quelconque des revendications 1 à 6, **caractérisé en ce qu'**il comporte une face destinée à être accolée à un substrat (1) qui est métallisée sur sa périphérie et recouverte d'une couche diamant (3) sur le reste de sa surface.

8. Composant semi-conducteur de puissance selon la revendication 7, **caractérisé en ce que** ledit composant est un composant IGBT.

## Claims

1. Electronic power module comprising at least one semi-conductor power component (2) arranged on an electrically insulating substrate (1), **characterised in that** said semi-conductor power component (2) has a face abutting said substrate (1), part of which face is covered with a layer of diamond (3) and part of which face is metallised (4), said metallised part (4) being in contact with a conductor track (5) provided on the surface of the substrate (1) and said part covered with diamond (3) being in register with an opening (8) provided in the substrate (1), said substrate (1) having a face opposite the semi-conductor component (2), which face is cooled by a heat-exchanging fluid (6), said fluid flowing into said opening (8) and over the surface of the part covered with diamond (3).

2. Electronic power module according to claim 1, **characterised in that that** face of the semi-conductor power component (2) which abuts the substrate is metallised over its periphery and covered with a diamond layer (3) over the rest of its surface.

3. Electronic power module according to any one of claims 1 to 2, **characterised in that** said diamond layer (3) is deposited on the semi-conductor power component (2) by CVD (Chemical Vapour Deposition).

4. Electronic power module according to any one of claims 1 or 3, **characterised in that** the diamond layer (3) covering the semi-conductor power component (2) forms a projecting portion which is inserted into the opening (8) in the substrate, said opening (8) having a complementary shape to the shape of the layer of diamond (3).

5. Electronic power module according to any one of claims 1 to 4, **characterised in that** the semi-conductor power component (2) is an IGBT component.

6. Electronic power module according to any one of claims 1 to 5, **characterised in that** said substrate (1) is made of aluminium nitride AlN or of alumina.

7. Semi-conductor power component for use in a power module according to any one of claims 1 to 6, **characterised in that** it has a face for abutting a substrate (1), which face is metallised over its periphery and covered with a diamond layer (3) over the rest of its surface.

8. Semi-conductor power component according to claim 7, **characterised in that** said component is an IGBT component.

## Patentansprüche

1. Elektronisches Leistungsmodul, aufweisend mindestens eine auf einem elektrisch isolierenden Substrat (1) angeordnete Halbleiter-Leistungskomponente (2), **dadurch gekennzeichnet, dass** die Halbleiter-Leistungskomponente (2) eine an das Substrat (1) angefügte Fläche aufweist, die zum Teil von einer Diamantschicht (3) bedeckt wird und zum Teil metallisiert (4) ist, wobei der metallisierte Teil (4) in Kontakt mit einer auf der Oberfläche des Substrats (1) ausgebildeten Leiterbahn (5) ist und der diamantenbedeckte (3) Teil einer in dem Substrat (1) ausgebildeten Öffnung (8) zugewandt ist, wobei das Substrat (1) eine der Halbleiterkomponente (2) entgegengesetzte Fläche aufweist, die mittels eines Kühlfluids (6) gekühlt wird, wobei das Fluid in die Öffnung (8) und auf die Fläche des diamantenbedeckten (3) Teils fließt.

2. Elektronisches Leistungsmodul gemäß Anspruch 1, **dadurch gekennzeichnet, dass** die Fläche der Halbleiter-Leistungskomponente (2), die an das Substrat angefügt ist, an ihrem Umfang metallisiert ist und auf dem Rest ihrer Fläche von einer Diamantschicht (3) bedeckt wird.

3. Elektronisches Leistungsmodul gemäß einem der Ansprüche 1 bis 2, **dadurch gekennzeichnet, dass** die Diamantschicht (3) mittels chemischer Gasphasenabscheidung auf die Halbleiter-Leistungskomponente (2) aufgebracht wird.

4. Elektronisches Leistungsmodul gemäß einem der Ansprüche 1 oder 3, **dadurch gekennzeichnet, dass** die die Halbleiter-Leistungskomponente (2) bedeckende Diamantschicht (3) eine in die Öffnung (8) des Substrats eingesetzte Überdicke ausbildet, wobei die Öffnung (8) eine zu der Form der Diamantschicht (3) komplementäre Form aufweist.

5. Elektronisches Leistungsmodul gemäß einem der Ansprüche 1 bis 4, **dadurch gekennzeichnet, dass** die Halbleiter-Leistungskomponente (2) eine IGBT-Komponente (IGBT, engl. Insulated Gate Bipolar Transistor [Bipolartransistor mit isolierter Gate-Elektrode]) ist.

6. Elektronisches Leistungsmodul gemäß einem der Ansprüche 1 bis 5, **dadurch gekennzeichnet, dass** das Substrat (1) aus Aluminiumnitrid AlN oder aus Aluminiumoxid ist.

7. Halbleiter-Leistungskomponente, die zum Ausstatten eines Leistungsmoduls gemäß einem der Ansprüche 1 bis 6 vorgesehen ist, **dadurch gekennzeichnet, dass** sie eine Seite aufweist, die zum Anfügen an ein Substrat (1) bestimmt ist, die an ihrem Umfang metallisiert ist und auf dem Rest ihrer Fläche von einer Diamantschicht (3) bedeckt wird.

8. Halbleiter-Leistungskomponente gemäß Anspruch 7, **dadurch gekennzeichnet, dass** die Komponente eine IGBT-Komponente (IGBT, engl. Insulated Gate Bipolar Transistor [Bipolartransistor mit isolierter Gate-Elektrode]) ist.
